# FASCICULE DE BREVET EUROPEEN

(11) **EP 2 035 844 B1**
(45) Date de publication et mention de la délivrance du brevet: **18.09.2013**
(21) Numéro de dépôt: 07765333.5
(22) Date de dépôt: 06.06.2007
(51) Int. Cl.: H01Q 3/08, G01R 29/10, G01R 29/08, G01R 31/00

(54) **SYSTEME DE MESURE DU DIAGRAMME DE RAYONNEMENT D'UNE ANTENNE D'EMISSION**
VORRICHTUNG ZUR MESSUNG DES ABSTRAHLUNGSDIAGRAMMS EINER SENDEANTENNE
SYSTEM FOR MEASURING THE RADIATION DIAGRAM OF A TRANSMISSION ANTENNA

(30) Priorité: 23.06.2006 EP 06116002
(43) Date de publication de la demande: 18.03.2009
(73) Titulaire: The Swatch Group Research and Development Ltd., 2074 Marin (CH)
(72) Inventeur: GRANGE, Matthieu, CH-1022 Chavannes (CH); CASAGRANDE, Arnaud, CH-2014 Bôle (CH)
(74) Mandataire: Ravenel, Thierry Gérard Louis
(86) Numéro de dépôt international: PCT/EP2007/055603
(87) Numéro de publication internationale: WO 2007/147736

(56) Documents cités:
- GB-A- 1 188 578
- JP-A- 2003 043 083
- US-A- 3 441 936
- US-A1- 2005 128 150
- US-B1- 6 191 744

## Description

L'invention concerne un système de mesure du diagramme de rayonnement d'une antenne d'émission. Le système comprend un dispositif de réception muni d'au moins une antenne de réception fixe pour capter le champ électromagnétique produit par une antenne d'émission à mesurer d'un dispositif électronique, et un dispositif de positionnement sur lequel est placé un élément de support du dispositif électronique. L'élément de support est de préférence un élément sphérique à l'intérieur duquel est placé le dispositif électronique. L'élément sphérique est maintenu sur le dispositif de positionnement par gravité sur trois points d'appui. Le dispositif de positionnement comprend en outre des moyens, tels qu'un organe d'entraînement pour entraîner notamment en rotation l'élément de support sphérique avec le dispositif électronique pour tourner l'antenne d'émission à caractériser par rapport à l'antenne de réception fixe. Le système de mesure comprend également des moyens de détection de la position ou orientation de l'antenne d'émission sur le dispositif de positionnement, et une station de traitement des données fournies par les moyens de détection et le dispositif de réception.

Pour effectuer une mesure du diagramme de rayonnement d'une antenne d'émission ou antenne test, il est utilisé au moins une antenne de réception dont les caractéristiques sont bien connues. Cette antenne de réception est séparée d'une certaine distance de l'antenne d'émission à mesurer, par exemple d'une distance inférieure à quelques mètres. Pour ce faire, l'antenne d'émission, qui fait partie d'un dispositif électronique, est placée avec les autres composants du dispositif électronique sur ou dans un élément de support. Cet élément de support est ensuite placé sur un dispositif de positionnement qui peut être de type aléatoire, c'est-à-dire susceptible de déplacer ou orienter l'élément de support dans n'importe quelle direction pour des opérations de mesure du champ électromagnétique produit par l'antenne d'émission.

Selon l'état de la technique comme décrit notamment par les documents de brevet US 6,191,744 et JP 2003-043083, il est connu d'effectuer une mesure du diagramme de rayonnement d'une antenne d'émission à l'aide d'au moins une antenne de réception déplacée autour de l'antenne d'émission. Pour ce faire, le dispositif électronique comprenant l'antenne d'émission est placé sur un support fixe, alors que l'antenne de réception est montée sur une structure mécanique, tels que des bras, pour le déplacement de l'antenne de réception par rapport à l'antenne d'émission. L'antenne de réception peut être déplacée autour de l'antenne d'émission à une distance fixe de l'antenne d'émission. Chaque position de l'antenne de réception est détectée par des moyens de détection de position liés à la structure mécanique. De cette façon, des signaux relatifs au champ électromagnétique captés par l'antenne de réception et des signaux de position sont fournis à une station de traitement des données de manière à calculer le diagramme de rayonnement de l'antenne d'émission.

Il est également connu du document de brevet US 2005/0128150 un système de mesure, qui comprend un dispositif de positionnement pour un dispositif émetteur, tel qu'un téléphone portable, et un dispositif de réception. Le dispositif de positionnement permet de faire tourner dans un plan horizontal le dispositif émetteur, alors que le dispositif de réception est monté rotatif sur une structure en forme d'arc centré sur la position du dispositif émetteur. De cette manière, une mesure du rayonnement de l'antenne d'émission du dispositif émetteur peut être effectuée dans toutes les directions.

Un inconvénient de tels systèmes de mesure de l'état de la technique réside dans le fait que la structure mécanique portant l'antenne de réception est relativement compliquée. Avec un tel agencement de mesure, cela ne permet pas de fournir des signaux de données à la station de traitement avec toute la précision requise pour le calcul du diagramme de rayonnement de l'antenne d'émission.

Le document de brevet US 3,441,936 présente un dispositif de positionnement d'un élément sphérique à l'intérieur duquel peut être placé une antenne d'émission. Cet élément sphérique est maintenu par gravité sur trois roues d'entraînement du dispositif de positionnement susceptibles d'orienter dans toutes les directions l'antenne d'émission. Lorsqu'une roue d'entraînement est entraînée pour bouger l'élément sphérique, l'élément sphérique dérape sur les deux autres roues d'entraînement. Ceci ne permet pas de garantir un bon positionnement de l'antenne d'émission ce qui constitue un inconvénient.

Le document de brevet GB 1,188,578 décrit un dispositif de montage d'un instrument lourd, tel qu'un dispositif ayant une antenne d'émission. Comme pour le précédent document, il est prévu un élément sphérique qui peut être positionné sur des éléments d'une plaque de base, tels que des billes ou sur un fluide dans un logement d'un support de base.

L'invention a donc pour objet de fournir un système de mesure du diagramme de rayonnement d'une antenne d'émission qui soit plus simple et plus précise pour fournir des signaux de données à une station de traitement de données afin de pallier les inconvénients de l'état de la technique.

A cet effet, l'invention concerne un système de mesure du diagramme de rayonnement d'une antenne d'émission cité ci-devant qui comprend les caractéristiques de la revendication indépendante 1.

Des formes particulières du système de mesure sont définies dans les revendications dépendantes 2 à 10.

Un avantage du système de mesure selon l'invention est que l'antenne d'émission est placée avec le dispositif électronique à l'intérieur d'un élément sphérique dans une position centrale de cet élément. De cette manière, l'élément sphérique ou sphère creuse peut être entraîné en rotation aléatoirement par l'organe d'entraînement dans toutes les directions sur le dispositif de positionnement pour que l'antenne d'émission tourne autour du centre de la sphère creuse. Cette antenne d'émission est alimentée en continu par le dispositif électronique, qui comprend par exemple une batterie ou un accumulateur rechargeable pour permettre la mesure du champ électromagnétique par l'antenne de réception fixe d'un dispositif de réception.

Avantageusement, l'organe d'entraînement comprend une roue en contact de la surface extérieure de la sphère creuse, et un support de cette roue d'entraînement. L'axe de rotation de la roue est monté à l'extrémité du support, qui est susceptible de tourner selon un autre axe passant par le point de contact de la roue sur la surface extérieure de la sphère creuse et le centre de la sphère creuse. Le support monté rotatif sur une structure mécanique du dispositif de positionnement, et la roue d'entraînement peuvent être entraînés en rotation par l'intermédiaire de moyens à air comprimé.

De préférence, aucune partie du dispositif de positionnement à proximité de l'antenne d'émission n'est composée de matériau métallique pour ne pas perturber la mesure du champ électromagnétique produit par l'antenne d'émission. De plus, l'antenne de réception et l'élément sphérique avec le dispositif électronique à antenne d'émission sont logés dans une chambre anéchoïque. Ceci permet d'éviter toute réflexion du champ électromagnétique contre des obstacles susceptibles de nuire à la mesure du rayonnement de l'antenne d'émission.

Avantageusement, le système de mesure comprend des moyens de détection de la position ou orientation de l'antenne d'émission, qui sont constitués par une caméra numérique, préférablement placée à proximité de l'antenne de réception. Grâce à cette caméra numérique reliée à une station de traitement de données, il est possible de connaître le mouvement de la sphère imposé par le dispositif de positionnement en temps réel. Des figures ou références sont également réparties uniformément sur la surface extérieure de la sphère creuse. Ceci permet à la caméra numérique et à un algorithme de reconnaissance de position mémorisé dans la station de traitement des données de reconnaître chaque position au cours du temps de la sphère creuse, donc de l'antenne d'émission. Ces figures sont de préférence des codes à barres circulaires codés sur 4 bits, ainsi qu'un bit supplémentaire de délimitation extérieure toujours noir sur la surface extérieure de la sphère de couleur claire (blanche). Ainsi, en associant une valeur de champ mesurée à une position mesurée, il est possible d'obtenir le diagramme de rayonnement d'une antenne émettrice.

Pour permettre une bonne prise d'image par la caméra numérique, il est avantageusement prévu un dispositif d'éclairage isotrope (uniforme) de la surface visible de l'élément sphérique ou sphère creuse. Comme toute partie à proximité de l'antenne d'émission doit être réalisée en un matériau non métallique, un ensemble de fibres optiques guide de la lumière fournie par une source de lumière distante pour illuminer l'élément sphérique. L'ensemble de fibres optiques est séparé en plusieurs sous-ensembles à proximité de la sphère creuse. Les extrémités des fibres optiques d'un sous-ensemble, par exemple au nombre de 6 par sous-ensemble, sont fixées dans un plot plastique fixé sur une structure d'éclairage. De préférence, 6 plots plastiques maintenant chacun 6 extrémités de fibres optiques sont fixés à distance égale l'un de l'autre sur la structure d'éclairage. Cette structure d'éclairage est configurée en forme d'anneau et placée juste devant l'élément sphérique du côté de la caméra numérique sans obstruer la vision de la sphère par la caméra numérique.

Les buts, avantages et caractéristiques du système de mesure du diagramme de rayonnement d'une antenne d'émission apparaîtront mieux dans la description suivante en regard des dessins sur lesquels :
- la figure 1 représente de manière simplifiée les différents éléments, qui composent le système de mesure du diagramme de rayonnement d'une antenne d'émission selon l'invention,
- la figure 2 représente une partie du dispositif d'éclairage pour illuminer l'élément sphérique posé sur le dispositif de positionnement du système de mesure selon l'invention,
- les figures 3a et 3b représentent une vue en coupe partielle dans le sens de la longueur et une vue de dessus d'une rotule à bille du dispositif de positionnement du système de mesure selon l'invention,
- la figure 4 représente une illustration des coordonnées sphériques utilisées pour la détermination de la position de l'élément sphérique sur le dispositif de positionnement du système de mesure selon l'invention,
- la figure 5 montre l'emplacement de chaque figure ou référence sur la surface extérieure de l'élément sphérique pour la détermination de la position de l'antenne d'émission sur le dispositif de positionnement du système de mesure selon l'invention,
- la figure 6 représente une figure sous la forme d'un code à barres circulaires à placer sur la surface extérieure de l'élément sphérique pour déterminer la position ou orientation de l'antenne d'émission du système de mesure selon l'invention, et
- la figure 7 représente les différents composants du dispositif de réception du système de mesure selon l'invention.

Dans la description suivante, tous les éléments du système de mesure du diagramme de rayonnement d'une antenne d'émission qui sont bien connus de l'homme du métier dans ce domaine technique ne sont relatés que de manière simplifiée.

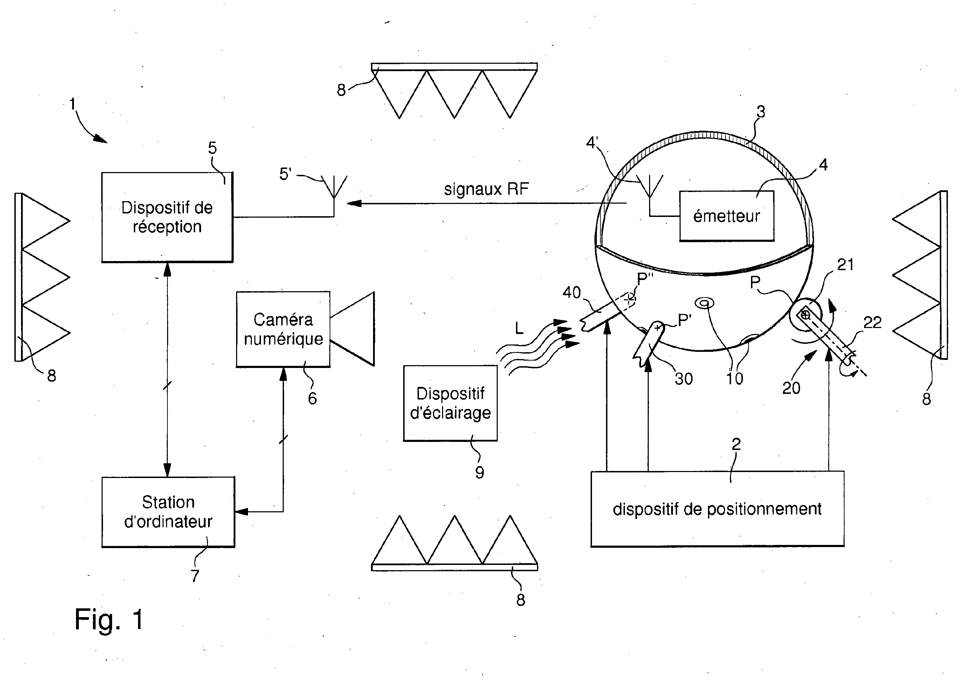

La figure 1 illustre de manière schématique tous les éléments du système de mesure 1 du diagramme de rayonnement d'une antenne d'émission 4' d'un dispositif électronique émetteur 4. Pour l'essentiel, le système de mesure 1 comprend tout d'abord un dispositif de positionnement 2 sur lequel est placé et maintenu sur trois points d'appui P, P', P" des membres 20, 30, 40 par gravité un élément de support sphérique 3 pour le dispositif électronique. Ledit dispositif électronique à antenne d'émission 4' à mesurer est maintenu à l'intérieur de cette sphère creuse 3, qui comprend deux parties, qui s'emboîtent par tout moyen connu l'une sur l'autre pour enfermer le dispositif électronique. L'antenne d'émission 4' est positionnée de préférence voisine du centre de cette sphère creuse.

Le système de mesure comprend encore un dispositif de réception 5 muni d'au moins une antenne de réception 5' pour capter le champ électromagnétique de l'antenne d'émission 4' (signaux RF), des moyens de détection 6 de la position ou orientation de l'élément sphérique en mouvement sur le dispositif de positionnement 2. Les signaux relatifs au champ électromagnétique captés par l'antenne de réception et des signaux de position fournis par les moyens de détection sont transmis automatiquement ou sur requête à une station de traitement des données, qui est de préférence une station d'ordinateur 7. Le dispositif de réception 5 et les moyens de détection, qui sont formés par une caméra numérique 6, peuvent être alimentés en énergie électrique indépendamment de la station d'ordinateur ou par l'intermédiaire de ladite station d'ordinateur.

Le dispositif de positionnement 2 n'est représenté par simplification sur la figure 1 que par les membres 20, 30, 40 supportant l'élément sphérique 3 pour les opérations de mesure du champ électromagnétique produit par l'antenne d'émission du système de mesure. Ce dispositif de positionnement 2 comprend donc un organe d'entraînement 20 en contact avec la surface extérieure de l'élément sphérique. Cet organe d'entraînement est configuré de telle manière à faire tourner aléatoirement dans toutes les directions l'élément sphérique 3 sur le dispositif de positionnement.

Cet organe d'entraînement 20 est constitué d'une roue 21 qui vient en contact de la surface extérieure de l'élément sphérique pour l'entraîner en rotation. La roue peut comprendre un élément sous forme d'anneau en caoutchouc disposé dans une rainure circulaire pour permettre d'entraîner l'élément sphérique sans glisser. L'axe de rotation de cette roue 21 est monté à l'extrémité d'un support 22 ou tige. Ce support 22 est susceptible de tourner selon un autre axe passant par le point de contact de la roue sur la surface extérieure de l'élément sphérique et le centre dudit élément. Ceci permet ainsi d'imposer une rotation aléatoire de l'élément sphérique par l'intermédiaire de la roue dans toutes les directions. Il peut être estimé un temps de 10 minutes, pour que l'élément sphérique parcoure toutes les positions. Pendant ce laps de temps, il peut être compté environ 6'000 mesures du champ électromagnétique émis par l'antenne d'émission.

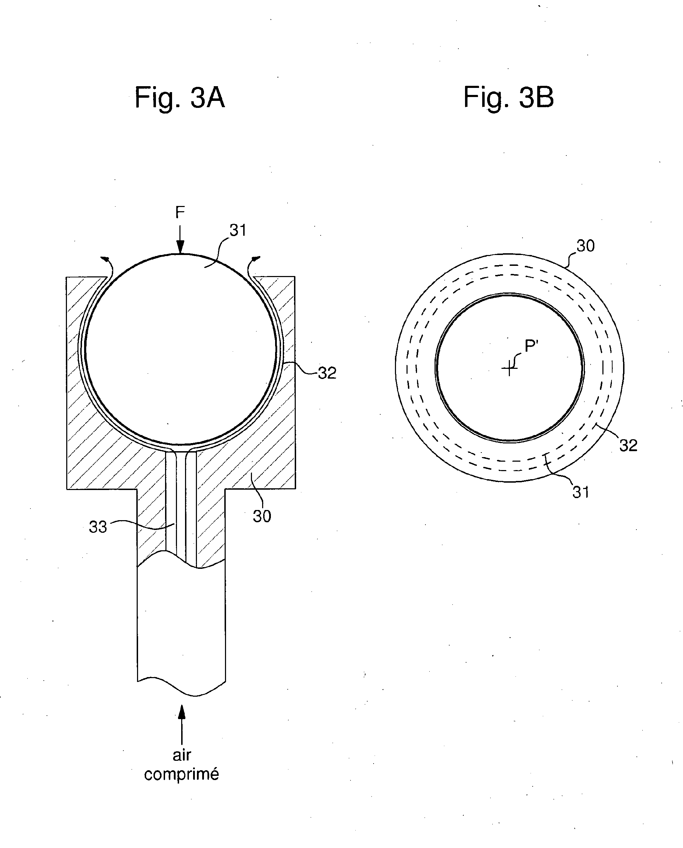

Le dispositif de positionnement 2 comprend encore deux rotules à bille 30 et 40 expliquées ci-après en référence aux figures 3a et 3b. Chaque bille des rotules est arrangée pour venir en contact de la surface extérieure de l'élément sphérique 3. Ainsi, les contacts de la roue 21 et de chaque bille des deux rotules 30, 40 constituent les trois points d'appui sur lesquels l'élément sphérique repose. Ces trois points d'appui peuvent être espacés régulièrement pour former les extrémités d'un triangle équilatéral disposé de préférence horizontalement. Bien entendu, le centre de gravité de l'élément sphérique 3 doit se trouver dans toute position à l'intérieur de ce triangle équilatéral pour être maintenu sur le dispositif de positionnement.

En lieu et place de trois roues d'entraînement d'un dispositif de l'art antérieur, qui constituaient les trois points d'appui de l'élément sphérique, une seule roue d'entraînement 21 ne dérape plus en contact de la surface extérieure de l'élément sphérique. Ceci permet à l'élément sphérique 3 de décrire aléatoirement avec beaucoup d'homogénéité l'ensemble de l'espace des positions. Cette roue d'entraînement est de préférence entraînée par un moteur ou turbine à air comprimé non représenté, qui est logé dans le support à proximité de ladite roue 21. Des conduits à air comprimé sont réalisés dans le support pour faire circuler l'air comprimé provenant d'un réservoir à air comprimé vers le moteur.

Un autre moteur ou turbine à air comprimé peut être utilisé pour entraîner en rotation le support 22 de la roue d'entraînement 21. Dans ce cas, un ensemble de poulies et de courroies d'entraînement, non représentés, entre ledit moteur et le support 22 peut permettre d'imposer la rotation souhaitée au support pour faire tourner l'axe de rotation de la roue d'entraînement. Avec cette seule roue d'entraînement, les sautillements de l'élément sphérique sur les trois points d'appui ont disparu. Le seul déplacement du centre de l'élément sphérique observable réside de son mal rond naturel et du jeu des roulements (poulies) de l'ordre du millimètre. Ceci est susceptible d'impliquer une erreur de calcul d'angle de l'ordre de 0.05 degrés du système de mesure, ce qui est négligeable.

Les figures 3a et 3b représentent une des rotules à bille 30 du dispositif de positionnement pour servir d'un des points d'appui de l'élément sphérique. Cette rotule 30, qui peut être de forme extérieure généralement cylindrique, comprend un logement 32 pour la bille en matière synthétique. Ce logement est dimensionné de telle manière que la bille est libre de rotation à l'intérieur de ce logement. Ce logement peut être de forme sphérique ou de forme cylindrique. De préférence, la rotule est réalisée en un matériau non conducteur et à faible coefficient de frottement, tel qu'en Téflon, pour la bille libre de rotation.

Une portion de la bille 31 débouche hors du logement 32 par une ouverture supérieure de la rotule 30 pour venir en contact de la surface extérieure de l'élément sphérique. Une force F représentant une partie du poids de l'élément sphérique est appliquée au point d'appui P' sur la bille. Cette ouverture est de diamètre inférieur au diamètre de la bille pour maintenir la bille à l'intérieur du logement 32.

Pour un logement de forme sphérique, la rotule comprend deux parties s'emboîtant l'une sur l'autre dans le sens de la longueur pour enfermer la bille dans le logement. Dans le cas d'un logement de forme cylindrique par contre, l'ouverture supérieure est réalisée dans un couvercle, non représenté, fermant partiellement le logement. La rotule est configurée également sous la forme d'une buse pour amener de l'air comprimé par un conduit 33 de la rotule jusque dans le logement 32 de la bille. De cette façon, la bille est maintenue dans son logement sur un coussin d'air.

Dans le cas où l'élément sphérique 3 est posé uniquement sur deux buses d'air comprimé, dont le débit est réglé, alors que le troisième point d'appui est la roue d'entraînement, il est facile de faire flotter et tourner l'élément sphérique. Toutefois, l'élément sphérique est dans certains cas animé d'un mouvement oscillant. Il se rapproche d'une buse, ce qui augmente la pression d'air et l'éjecte quelque peu. Dans le cas où la pression locale, donc la force de soutien, diminue, l'élément sphérique retombe sur la buse qui l'éjecte à nouveau. De ce fait avec ces buses d'air comprimé, cela nécessite un réglage de la pression d'air en fonction du poids de la sphère, ce qui est résolu par les rotules à bille selon l'invention. Un filet d'air comprimé sort de l'ouverture du logement autour de la bille, dont la pression est fonction du poids de l'élément sphérique, ce qui évite le problème de simples buses à air comprimé. L'élément sphérique peut librement être entraîné en rotation sans à-coup dans toutes les directions.

Pour résoudre un éventuel problème lié au déséquilibrage de l'élément sphérique sur les trois points d'appui, il peut être prévu d'augmenter le poids de l'élément sphérique en introduisant une rotule supplémentaire à son sommet ou rotule de pression. Cette rotule peut être réalisée à l'aide d'une bille coulissant dans un tuyau d'air comprimé et permettant de générer à l'image d'un ressort une force constante sur l'élément sphérique. La résultante de cette pression normale au contact de la roue motrice d'entraînement permet une meilleure adhérence de ladite roue.

La majeure partie des composants du système de mesure est placée à l'intérieur d'une chambre anéchoïque illustrée par les éléments référencés 8 sur la figure 1. Ceci permet d'éviter toute réflexion du champ électromagnétique produit par l'antenne d'émission 4' contre des obstacles susceptibles de nuire à la mesure du rayonnement de l'antenne d'émission. De plus, aucune partie du dispositif de positionnement à proximité de l'antenne d'émission, c'est-à-dire à l'intérieur de ladite chambre, ne doit être composée de matériau métallique pour ne pas perturber la mesure du champ électromagnétique produit par l'antenne d'émission. Les moyens d'entraînement du dispositif de positionnement 2, qui sont en plastique ou en matériau non conducteur, fonctionnent par l'intermédiaire d'air comprimé. Ces moyens d'entraînement peuvent être des moteurs ou turbines à air comprimé reliés par des'tuyaux à robinets à un réservoir d'air comprimé. Ces moteurs non métalliques pour l'entraînement de la roue et du support de roue selon deux axes peuvent être placés donc à proximité de l'antenne d'émission.

De manière à déterminer précisément la position ou orientation de l'élément sphérique 3, donc de l'antenne d'émission 4' à mesurer qu'il comprend, il est prévu de placer des figures ou références spécifiques 10 sur la surface extérieure de l'élément sphérique 3. Ces figures ou références sont constituées par des codes à barres circulaires, chaque code à barres circulaires définissant une position précise de l'élément sphérique sur le dispositif de positionnement. Chaque code à barres circulaires 10 peut être imprimé ou collé sur la surface extérieure de la sphère ou réalisé par tout autre moyen.

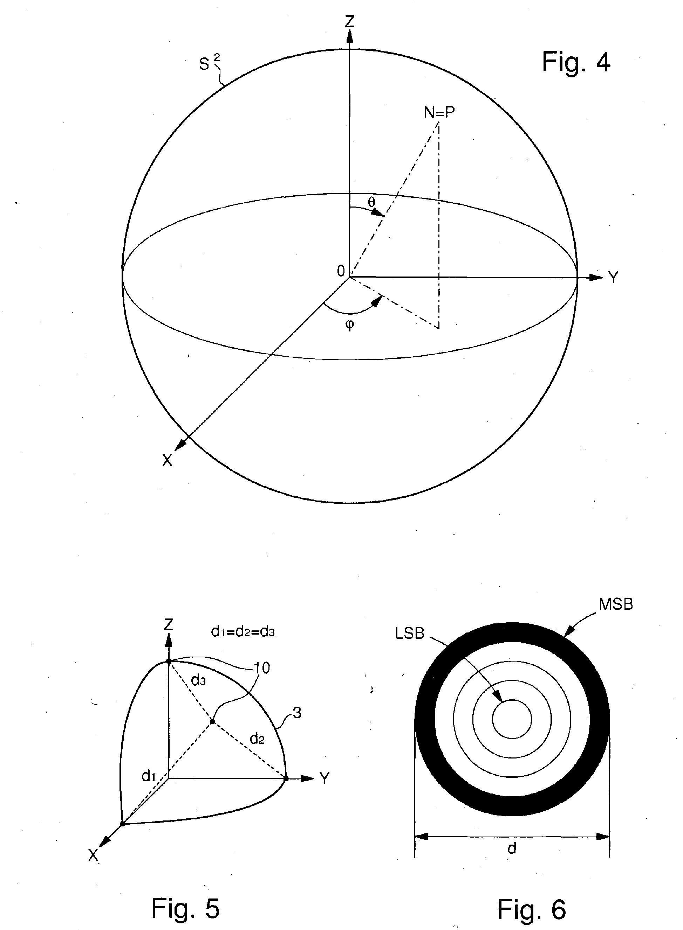

Il est prévu par exemple 14 codes à barres circulaires différents, qui sont répartis uniformément sur la surface extérieure de l'élément sphérique comme expliqué ci-après en référence aux figures 5 et 6. Chaque code à barres circulaires étant codé sur 4 bits, ainsi qu'un bit de délimitation extérieure de couleur différente de la couleur de la surface extérieure de l'élément sphérique. De préférence, la surface extérieure de l'élément sphérique est de couleur claire, par exemple de couleur blanche, alors qu'au moins le bit supplémentaire de délimitation extérieure est de couleur foncée, par exemple de couleur noire.

Pour améliorer la prise d'images par la caméra numérique, qui doit être en mesure de prendre par exemple 15 images par seconde, le système de mesure 1 comprend encore un dispositif d'éclairage isotrope 9. Ce dispositif d'éclairage 9 est configuré de telle manière à fournir des faisceaux de lumière L en direction d'au moins une moitié de la surface extérieure de l'élément sphérique 3 du côté de la caméra numérique 6.

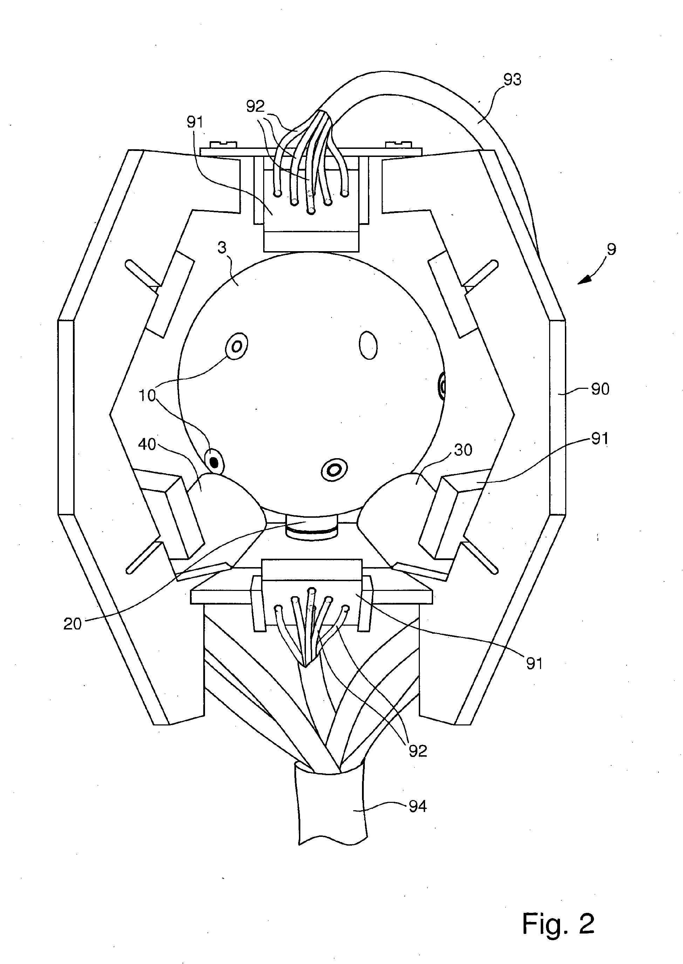

Le dispositif d'éclairage 9 de l'élément sphérique ou sphère creuse 3, qui est munie des différents codes à barres circulaires, et qui est posée sur les trois points d'appui P, P', P" des membres 20, 30, 40 du dispositif de positionnement, est maintenant expliqué en référence à la figure 2.

Il a été démontré que pour une reconnaissance optique de position, le système de mesure possède une grande sensibilité à l'homogénéité de l'éclairage. Auparavant, il était utilisé un éclairage par des sources de lumière du type LED disposées entre des cônes d'absorption de la chambre anéchoïque. Toutefois, en utilisant des LED de 1 W, il a été remarqué un manque de puissance pour un bon éclairage. De plus, l'angle d'ouverture des LED est de l'ordre de 110°, ce qui nécessite l'utilisation de lentilles de focalisation devant les LED. En plus de cela, leur fixation et leur alimentation électrique pose un problème dans la chambre anéchoïque de par une connexion par fil métallique jusqu'à chaque LED, ce qui peut nuire à la mesure du rayonnement de l'antenne d'émission.

Pour le dispositif d'éclairage selon l'invention, il est utilisé un ensemble de fibres optiques 92, dont une extrémité de chaque fibre est disposée à proximité d'une source de lumière (150 W) non illustrée pour recevoir de la lumière. Cette source de lumière est placée par exemple en dehors de la chambre anéchoïque non illustrée. Cette source de lumière peut être du type de celles utilisées pour des éclairages coaxiaux de microscopes. L'ensemble de fibres optiques est regroupé dans une gaine 94 en matériau plastique pour être dirigé dans la chambre anéchoïque jusqu'à une structure d'éclairage 90 en matière plastique.

Les fibres optiques 92 utilisées sont de préférence des fibres synthétiques dont l'extrémité du côté de la source de lumière est distante par exemple de 3.5 cm de cette source de lumière pour éviter que les fibres brûlent. De par leur souplesse, de telles fibres synthétiques peuvent être aisément manipulées. Leur diamètre peut être de l'ordre de 1 mm.

L'ensemble de fibres optiques regroupe 36 fibres optiques suffisamment longues (4 m) protégées par la gaine extérieure en matière plastique 94. L'ensemble de fibres optiques est encore réparti en plusieurs sous-ensembles de fibres optiques protégés par une autre gaine 93 en matière plastique à l'intérieur de la gaine extérieure 94. De préférence, 6 sous-ensembles de 6 fibres optiques protégés chacun par une autre gaine 93.

Les extrémités des fibres optiques de chaque sous-ensemble sont fixées dans un plot carré en plastique de 3.5 cm de côté et 1 cm d'épaisseur. Les extrémités des fibres optiques sont disposées à égale distance l'une de l'autre dans chaque plot sous la forme de triangles équilatéraux de 1.5 cm de côté. 6 plots plastiques 91 sont régulièrement disposés sur la périphérie de la structure d'éclairage 90 en forme d'anneau. Les extrémités des fibres optiques fixées dans les plots plastiques de chaque sous-ensemble sont orientées de manière à diriger des faisceaux de lumière en direction du centre de l'élément sphérique. De cette manière, l'éclairage de l'élément sphérique est rendu homogène grâce à l'ensemble de fibres optiques et leur agencement à proximité de l'élément sphérique sans l'emploi de matériau métallique.

La structure d'éclairage 90 en forme d'anneau est disposée entre la caméra numérique et l'élément sphérique 3, mais à proximité de l'élément sphérique. Elle peut être reliée mécaniquement au dispositif de positionnement. La dimension de cette structure d'éclairage est légèrement supérieure au diamètre de l'élément sphérique, qui peut être de l'ordre de 12 cm. La caméra numérique, qui peut être distante d'un ou deux mètres de l'élément sphérique, doit pouvoir observer tout l'élément sphérique à travers la structure d'éclairage 90.

En référence aux figures 4 à 6 suivantes, il est décrit la manière d'opérer du système de mesure pour la détermination du diagramme de rayonnement de l'antenne d'émission. Il est tout d'abord à noter que pour effectuer toutes les opérations de mesure, l'antenne d'émission est toujours active de manière à générer un champ électromagnétique à fréquence, qui peut être de l'ordre du GHz. Le dispositif électronique à antenne d'émission comprend donc une propre source d'alimentation électrique, telle qu'une batterie ou un accumulateur rechargeable étant donné qu'il est enfermé dans l'élément sphérique. Avec ce système de mesure, il peut être prévu de mesurer l'antenne d'émission d'un téléphone portable (GSM) par exemple, ou tout autre appareil susceptible d'être enfermé dans l'élément sphérique.

Pour les mesures de position de l'élément sphérique avec les différents codes à barres circulaires qu'il comprend sur sa surface extérieure, les types de mesure sont basés sur les angles d'Euler θ, Φ, ψ, qui définissent l'élévation, l'azimut et la polarisation des plans de rotation. Dans des applications mécaniques, il est préférable d'utiliser les angles d'Euler pour déterminer la position d'un solide, tel que l'élément sphérique.

Un point P situé dans un espace tridimensionnel est exprimé généralement par trois coordonnées P(x,y,z). Ces coordonnées dépendent du type de coordonnées choisi (ou référentiel). Le référentiel cartésien comporte 3 vecteurs orthonormés **x**, **y**, **z**. En fonction du type d'application, ce référentiel utilisé change pour faciliter les calculs ou la visualisation.

La position d'une antenne dans l'espace est caractérisée par 6 valeurs. Les 3 premières valeurs ne sont autres que les coordonnées de son centre de gravité. Les 3 autres valeurs sont les 3 angles d'Euler θ, ϕ, ψ (élévation, azimut, polarisation des plans de rotation) où uniquement deux angles sont indiqués sur la figure 4.

Le dispositif de positionnement est capable de placer l'élément sphérique qui contient l'antenne d'émission à mesurer dans n'importe quelle position ou orientation, soit dans la totalité de l'espace des trois angles d'Euler (élévation θ, azimut ϕ et polarisation ψ).

Du point de vue de la mesure, un tel dispositif de positionnement est très efficace, car il permet de mesurer une antenne inconnue dans toutes les polarisations linéaires avec une simple antenne de polarisation linéaire fixe, dite antenne de réception. En effet, pour un point donné de la surface S² de l'élément sphérique, toutes les polarisations comprises entre 0 et 360° sont mesurables. En fait, seules les polarisations entre 0 et 180° suffisent, car le récepteur ne fournit aucune information sur la phase du champ **E** mesuré, et une polarisation de 10° donne la même valeur de champ mesuré qu'une polarisation de 190°.

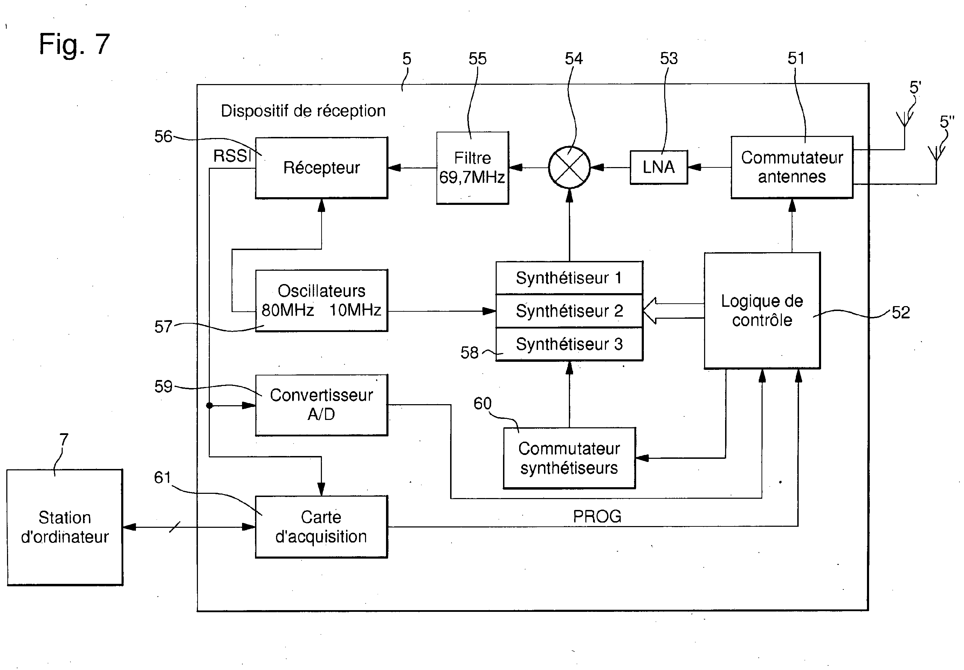

Comme la phase de **E** mesuré est inconnue, une seule mesure remplit en fait deux positions de l'espace θ, ϕ, ψ, car IE (θ, ϕ, ψ) I = IE(θ, ϕ, ψ + 180°)I. Par contre, ces informations sur la valeur absolue des diverses polarisations ne permettent pas de déterminer le sens de polarisations circulaires de manière simple. Pour ce faire, il faut utiliser simultanément deux antennes de réception de type circulaire lévogyre et dextrogyre pour déterminer le sens de rotation du vecteur **E** comme montré symboliquement en référence à la figure 7 expliquée ci-après. Cependant, la simple mesure complète (ψ compris entre 0 et 180°) avec une antenne linéaire permet de déterminer rapidement l'ellipse de polarisation, si on sait à l'avance que la polarisation attendue est de type circulaire.

Dans le système de mesure selon l'invention, il peut être utilisé successivement deux antennes de polarisation linéaire orthogonales. Il est par conséquent redondant de mesurer plusieurs polarisations pour un même point de la surface de la sphère, qui correspond à un point du diagramme de rayonnement. Ainsi pour une mesure du diagramme de rayonnement en puissance pour des antennes à polarisation de type linéaire, il suffit d'une valeur de l'angle de polarisation pour chaque couple d'angles d'élévation (θ) et d'azimut (ϕ). On calcule facilement E² = Eₓ² + E_{y}². Il faut tout de même prendre garde, car si la polarisation est de type circulaire, le calcul est faussé de 3 dB.

Le logiciel compris dans la station d'ordinateur permet d'afficher donc le plan des angles élévation - azimut, et lorsque ce dernier est suffisamment rempli, l'utilisateur peut décider de terminer la mesure. Dans l'espace tridimensionnel des trois angles d'Euler, ce plan correspond à une projection sur le plan élévation - azimut et se remplit par conséquent bien plus vite que l'espace tridimensionnel précité.

Pour une question de simplicité du système, la mesure selon les deux polarisation Eₓ et E_{y} est effectuée successivement et non simultanément. Comme le système de mesure permet de mesurer en fait 40 fois le champ **E** entre deux positions (20 fois Eₓ et 20 fois E_{y} de manière entrelacée) et si la vitesse de rotation de l'élément sphérique est suffisamment faible, on peut considérer que la position de deux échantillons successifs Eₓ et E_{y} est quasiment la même. Il est bien sûr possible d'interpoler les champs mesurés ainsi que les positions de manière à déterminer exactement Eₓ et E_{y} au même endroit. Les deux premières acquisitions à une position mesurée et calculée donnée sont utilisées tout en considérant leurs deux positions comme identiques pour le calcul de E² = Eₓ² + E_{y}².

Il peut aussi être imaginé de mesurer simultanément Eₓ et E_{y}. Dans ce cas, la chaîne de réception doit être doublée, et une calibration relative de deux portions de systèmes de mesure doit être opérée, ce qui n'est pas nécessaire dans le cas du système de mesure selon l'invention étant donné qu'il est utilisé un même récepteur pour les deux mesures.

Pour le calcul de la rotation dans l'espace tridimensionnel, il doit tout d'abord être précisé que la caméra numérique produit une déformation sphérique de l'image observée, notamment de l'élément sphérique ou sphère creuse sur le dispositif de positionnement. Pour une distance supérieure à 1 m entre la caméra et l'élément sphérique, l'erreur est inférieure à 0.2 %.

En négligeant la déformation sphérique développée ci-dessus, il devient facilement possible de calculer la 3^{éme} coordonnée (y, z étant mesurés, x est déterminé par l'équation x = (r² - y² - z²)^{1/2}). La rotation selon les trois angles d'Euler est une transformation dite de changement de base. La résolution mathématique de cette transformation nécessite trois équations à savoir une équation par vecteur de référence. Cependant, la rotation est une transformation isométrique qui a pour propriété de conserver les angles. Dans le cas de l'élément sphérique de l'invention, la mesure de deux vecteurs transformés suffit à déterminer complètement le changement de base, car la troisième inconnue est contenue dans la propriété d'isométrie précitée. Une manière extrêmement simple et efficace de résoudre le système est de construire un troisième vecteur par produit vectoriel des deux premiers et de l'inclure dans un système de résolution matricielle.

On remarque que la matrice inverse associée à chaque couple de vecteurs peut être facilement pré-calculée et stockée en mémoire dans la station d'ordinateur avant la phase de mesure afin de diminuer la charge processeur et d'augmenter la puissance disponible pour la reconnaissance de formes ou des codes à barres circulaires. La matrice R ainsi calculée contient les valeurs déjà transformées par les fonctions trigonométriques traditionnelles.

Lors de la mesure, il est indiqué le nombre de points parcourus sur l'élément sphérique. Une information objective sur la progression des mesures est ainsi obtenue. Cette analyse se base sur la matrice de rotation. Une fois calculée, on dispose des trois angles d'Euler. En considérant θ et ϕ, et en se basant sur la représentation de la figure 4 des coordonnées sphériques, cela revient à regarder si le point P parcourt tous les points de la sphère S². Ceci équivaut à observer si (θ, ϕ) parcourent tous les points du rectangle R = [0, π] x [-π, π] où θ est la longitude de P et ϕ est la latitude de P. Les pôles Nord et Sud de S² sont des points singuliers pour les coordonnées sphériques. Il faut par conséquent prendre quelques précautions pour calculer θ et ϕ.

Concernant la reconnaissance de la position ou orientation de l'élément sphérique sur le dispositif de positionnement, il est utilisé une caméra numérique du type MOS en noir et blanc à 768 x 1024 pixels. Cette caméra prend 15 images/s et fournit un signal correspondant à l'exposition à la station d'ordinateur qui comprend mémorisé un logiciel de reconnaissance rapide et précis. La caméra étant en noir et blanc, il est donc possible de travailler sur les formes des figures, qui sont de préférence des codes à barres circulaires 10. Les figures choisies (codes à barres circulaires) ont des dimensions qui ne dépassent pas 12 mm. Lorsque l'élément sphérique remplit l'image prise par la caméra, il y a 768 pixels sur 12 cm, soit 76.8 pixels par figure (12 mm), ce qui suffit. Etant donné la forme de l'élément sphérique, il est préférablement utilisé des codes à barres circulaires pour garnir la surface extérieure de l'élément sphérique. Si la convexité de l'élément sphérique est négligée, la projection sur un plan tangent transforme les cercles en ellipses. Le centre d'un cercle se transforme en centre de l'ellipse dont la position définit exactement celle du cercle donc de la figure en code à barres circulaires.

Afin de voir correctement un nombre de codes à barres circulaires supérieur à deux sur l'image prise par la caméra, il est réparti 14 codes à barres circulaires sur l'élément sphérique de la manière suivante, 2 pour chaque pôle, 4 sur l'équateur, 4 pour chaque hémisphère comme montré partiellement à la figure 5. Chaque figure 10 située sur les hémisphères est équidistante au pôle et à deux figures sur l'équateur.

Il est donc utilisé 4 bits pour coder 14 figures (codes à barres circulaires), ainsi qu'un bit de délimitation extérieure toujours noir, qui définit le bord de la figure comme montré à la figure 6. Le centre de chaque code à barres circulaires définit le bit de poids faible (LSB), alors que le bit extérieur définit le bit de poids fort (MSB). Chaque bit à l'état 1 est de couleur noire, alors que chaque bit à l'état 0 est de couleur claire, notamment de couleur blanche. Avec des motifs de 12 mm de diamètre, il y a environ 7.68 pixels par barre de codage.

Ci-dessous, il est représenté un tableau de la position des figures sur la surface extérieure de l'élément sphérique avec le code en hexadécimal et les coordonnées sphériques de la position (en cm) :

| Position | Code en hexadécimal | Position en coordonnées cartésiennes |
|---|---|---|
| Pôle Nord | 1 0 0 1 1 | (0, 0, 6) |
| Pôle Sud | 1 0 1 1 1 | (0, 0, -6) |
| Equateur | 1 0 0 0 0 | (6, 0, 0) |
| | 1 1 1 0 0 | (0, 6, 0) |
| | 1 0 0 1 0 | (-6, 0, 0) |
| | 1 1 0 0 0 | (0, -6, 0) |
| Hémis. Nord | 1 0 1 0 0 | (3.46, 3.46, 3.46) |
| | 1 1 0 1 1 | (-3.46, 3.46, 3.46) |
| | 1 1 1 1 0 | (-3.46, -3.46, 3.46) |
| | 1 0 1 1 0 | (3.46, -3.46, 3.46) |
| Hémis. Sud | 1 0 0 0 1 | (3.46, 3.46, -3.46) |
| | 1 1 1 0 1 | (-3.46, 3.46, -3.46) |
| | 1 0 1 0 1 | (-3.46, -3.46, -3.46) |
| | 1 1 0 0 1 | (3.46, -3.46, -3.46) |

Pour le calcul de la rotation dans la station d'ordinateur, la matrice de rotation définit la rotation de l'élément sphérique par rapport à une position initiale sur le dispositif de positionnement. Cependant, dans le cas de l'établissement du diagramme de rayonnement, la rotation habituellement décrite est celle de l'antenne de réception donc celle de la caméra numérique par rapport à l'élément sphérique contenant l'antenne émettrice mesurée. Il s'agit donc de la rotation inverse (celle du mouvement relatif), notée R ⁻¹. Comme R est une transformation isométrique, R ⁻¹ est directement égale à la transposée de R notée R^{T}. Il reste donc à reconstruire les valeurs d'angle θ, ϕ, ψ. Cette reconstruction est assurée par une procédure appelant les fonctions trigonométriques inverses dans un ordre bien précis afin de lever les indéterminations possibles.

Pour les opérations de traitement de l'image captée par la caméra numérique 6 présentée à la figure 1 dans la station d'ordinateur 7, une phase de calibration est tout d'abord effectuée pour détecter le centre de l'élément sphérique 3, ainsi que la mesure de son rayon. Par la suite, une reconnaissance de deux figures 10 (codes à barres circulaires) de l'image et le calcul de leurs positions sont effectués. Puis une estimation des erreurs de calculs introduites est effectuée. Pour le système de mesure, il est exécuté donc 4 séquences distinctes, qui sont la calibration, l'initialisation des entrées/sorties, le calcul des positions et l'acquisition des champs Eₓ, E_{y}, et la sauvegarde des données.

Pour la calibration, la première opération consiste à calculer le rayon et le centre du cercle passant par le contour de l'élément sphérique 3. Elle détermine une référence et permet de diminuer la surface d'image à traiter. Seule une zone carrée de 0.95·rayon de côté, centré sur l'élément sphérique est conservée. Ensuite, l'image est numérisée. Le seuil optimal est déterminé par une méthode statistique.

Concernant les initialisations, les entrées/sorties sont initialisées en assignant les différents ports d'entrée/sortie d'une carte d'acquisition reliée à la station d'ordinateur aux différents signaux. Une entrée analogique est utilisée pour l'acquisition de la puissance du champ (RSSI Receive Signal Strength Indicator en terminologie anglaise). Une entrée numérique est assignée au signal d'ouverture de la caméra, et une sortie numérique délivre un signal carré à 600 Hz. Ce signal multiplexe temporellement Eₓ et E_{y}.

La séquence du calcul et d'acquisition comporte deux boucles en parallèle. Elles peuvent être interrompues par l'utilisateur du système de mesure. Une boucle génère le signal carré de 600 Hz et échantillonne les données du signal d'ouverture et des signaux de puissance RSSI (puissances des champs Eₓ et E_{y}). A chaque itération, ces données sont stockées dans un tableau qui se remplit au fur et à mesure de la progression du programme. La deuxième boucle calcule la position de l'élément sphérique filmée. A chaque itération, l'image est analysée pour déterminer les deux figures visibles les plus proches du centre et leur position en pixels. Les angles d'Euler sont ensuite calculés puis stockés dans un tableau. Finalement une sauvegarde de toutes les mesures effectuées est opérée.

Les signaux de puissance RSSI Eₓ et E_{y} sont mesurés selon une échelle logarithmique. La mesure qu'il est effectué nécessite Eₓ² et E_{y}² qui est facilement obtenu par sommation de deux signaux de puissance RSSI successifs. Aussi, comme Eₓ² + E_{y}² = E_{y}² + Eₓ², il n'est pas nécessaire de déterminer s'il s'agit d'Eₓ ou E_{y} dans le cas du système de mesure. Si cette option devenait nécessaire, il faudrait alors encore échantillonner le signal commandant la polarisation.

L'algorithme de détection de positions des figures nécessite un référentiel précis, afin d'éviter une erreur systématique sur les positions calculées. Il a donc été développé deux algorithmes de détection automatique, qui sont une méthode par seuillage et une méthode par intercorrélation.

La méthode par seuillage se base sur la détection de contour par seuillage. Un flanc montant est repéré sur des segments placés en arc de cercle sur l'hémisphère supérieur de l'élément sphérique. Une fois que les points sont trouvés, un algorithme des moindres carrés interpole l'équation du cercle correspondant. En utilisant cet algorithme, il est remarqué que l'ombre se trouvant sur le bord de l'élément sphérique dû à l'inhomogénéité de l'éclairage perturbe la détection de contour. Un algorithme plus robuste est ainsi indispensable.

La méthode par intercorrélation utilise la corrélation de deux images afin de trouver les coordonnées du cercle délimitant le contour de l'élément sphérique. La première image est celle prise par la caméra numérique 6. La deuxième image représente un disque blanc dont le rayon est connu centré sur le fond noir. S'il est calculé la fonction d'intercorrélation, son maximum permet de déterminer le centre de l'élément sphérique. Pour trouver le rayon, une itération du calcul avec un cercle de référence à rayon variable est effectuée.

Pour une image de 200 x 200 pixels, le temps de calcul est de l'ordre de la seconde. Il est donc très long de le faire sur une image de 768 x 1024 pixels. Par conséquent, seules certaines parties de l'image sont exploitées. Sachant qu'il faut 3 points pour déterminer un cercle, 3 zones sont prises dans l'image.

Sur la base d'une fonction donnant le maximum de la somme des fonctions d'intercorrélation bidimensionnelles des 3 zones, il est possible de détecter l'indice de la colonne et de la ligne du maximum et de calculer ainsi la position du centre de l'élément sphérique. Le calcul est ensuite itéré avec des images dont le rayon varie. Pour ce faire, il est utilisé une méthode géométrique. Il est itéré 4 fois sur un rayon variant de 280 à 380 par pas de 25. Les deux rayons sont repérés avec lesquels la fonction d'intercorrélation est maximum pour réitérer dans l'intervalle 5 fois par pas de 5. Une dernière itération avec des pas de 1 détermine le rayon. Cette méthode évite d'itérer sur tous les rayons.

Pour effectuer correctement le produit d'intercorrélation de deux images, il faut annuler leurs composantes continues. La moyenne des éléments de l'image est donc soustraite de l'image originale avant le produit d'intercorrélation. Après plusieurs tests, il est remarqué que le rayon trouvé dépend fortement de la valeur de la composante DC. La valeur continue sur 256 niveaux vaut 45.

Pour la détection manuelle, il est remarqué que les résultats des deux algorithmes décrits ci-dessus dépendent fortement de l'éclairage et donc de la composante DC de l'image source. C'est pourquoi il est opté pour une calibration manuelle par l'utilisateur et non une détection automatique. L'oeil humain permet de distinguer le contour de l'élément sphérique de manière quasi parfaite et ceci permet d'éviter une erreur inutile qui fausserait la totalité des mesures.

Il est décrit maintenant un algorithme de détection de la position des figures. Avant toute chose, les limitations liées à la reconnaissance des figures doivent être bien définies. L'éclairage de l'élément sphérique donne naissance à une série de réflexions spéculaires qui peuvent localement détruire le contraste des figures 10 (codes à barres circulaires) et engendrer des erreurs quant à la position et au codage des objets.

Le temps d'exposition de la caméra 6 génère un flou sur le contour des figures, pour une vitesse de rotation et une position de figure donnée. En considérant une figure sur la périphérie de la sphère et une vitesse de rotation de 1 tour/s, le flou pour un temps d'exposition de 10 ms est de Δd = 10ms·(2π/1000)·0.06m, ce qui équivaut à 4 mm. Le temps d'exposition finalement choisi est d'environ 3 ms. D'autre part, si une des deux figures est proche du centre et que l'autre est en périphérie et dans le cas d'une rotation de polarisation, l'angle entre les deux figures peut être distordu.

La reconnaissance de position proprement dite utilise deux fonctions qui opèrent sur une image binaire et utilisent des algorithmes propres au traitement d'image. Concernant l'algorithme de détection du type de figure, une fois la position de l'élément sphérique déterminée et les calculs du centre, du grand axe et du petit axe effectués, une procédure de reconnaissance de figure permet de déterminer la figure 10 observée. Une fois les figures définies, ces dernières sont représentées par leur centre et par leurs 2 axes.

Un premier algorithme traite la figure détectée de manière à sélectionner le demi grand axe le plus représentatif. Comme les réflexions apparaissent généralement sous forme de moindres contrastes et par une plus grande luminosité, la moyenne des luminosités selon les deux demi grands axes est comparée et il est choisi la valeur la plus faible. Le cercle noir plein étant un motif interdit, un second algorithme extrait la ligne d'image selon le demi grand axe sélectionné et supprime ensuite le niveau continu par soustraction de la valeur moyenne. Un troisième algorithme multiplie et somme le profil obtenu ci-dessus avec 14 vecteurs représentatifs des 14 figures. La taille de ces vecteurs, ainsi que celle du demi grand axe est directement déduit par calcul à partir du rayon de l'élément sphérique obtenu lors de la phase de calibration. La figure est déterminée par le maximum des 14 multiplications - produits.

La taille du vecteur source varie selon la position de la figure sur l'élément sphérique plus petite dans les bords. La taille des vecteurs n'est donc pas toujours égale. En supposant que la taille du vecteur source vaut N, plutôt que de supprimer des éléments du vecteur, ce qui provoquerait un déphasage, il est répété les éléments du vecteur source 5 fois (dimension = 5·N). Les tailles des vecteurs sont ainsi égales et l'algorithme peut fonctionner.

Le graphe θ - ϕ des positions calculées est affiché en continu sur l'écran de la station d'ordinateur. Il peut être prévu également d'afficher l'image.prise en temps réel avec les figures délimitées par un rectangle. Ceci permet d'observer facilement les figures détectées. Il peut être prévu également d'afficher un cube dont le mouvement correspond à celui de l'élément sphérique. L'affichage est mis à jour pour chaque image. En cas d'erreur, la dernière position correcte est conservée.

Lors de la sauvegarde, le programme dans la station d'ordinateur 7 stocke 6 vecteurs, à savoir le signal d'exposition, les signaux de puissance RSSI (Eₓ/E_{y} imbriqués temporellement l'un après l'autre), θ, ϕ, ψ, et le booléen d'erreur. Ceux-ci n'ont pas tous la même longueur. En effet, l'acquisition du signal d'exposition et des signaux de puissance RSSI est faite simultanément afin de synchroniser les mesures avec les positions calculées. Le post-traitement comporte 3 étapes, qui sont l'attribution de la bonne position au bon signal de puissance RSSI mesuré, la vérification de la rotation effectuée et la suppression des erreurs éventuelles, et l'affichage des résultats.

A chaque itération, 40 valeurs de signaux de puissance RSSI sont mesurées pour une position calculée. Les vecteurs du signal d'exposition et des signaux de puissance RSSI ont N éléments tandis que θ, ϕ, ψ, et le booléen d'erreur possèdent N/40 éléments. Ces valeurs sont stockées dans un tableau.

Les deux valeurs de RSSI synchrones avec une image suivent directement le flanc descendant du signal d'exposition. Ensuite le premier élément des vecteurs position θ, ϕ, ψ, et le booléen d'erreur est supprimé car le signal de puissance RSSI au temps t est attribué à la position calculée t+1.

Un moyen de vérifier si la rotation calculée est correcte est de calculer la différence d'angle entre deux rotations successives. On estime la distance entre deux rotations successives d'un point sur une sphère de rayon 1. Si cette distance est supérieure à un seuil, il y a une erreur.

La synchronisation entre la mesure et le calcul de position est fondamentale et constitue une des difficultés principales du système de mesure. En effet, le logiciel de traitement d'image permet de gérer une série de traitements sur un flux d'images, mais l'horaire d'obtention des résultats de calculs de position n'est pas déterministe. Cet horaire dépend en fait directement de la charge du système, de l'activité des tâches bas niveau de la station d'ordinateur, de la carte réseau et des accès disques. Il faut donc absolument disposer d'une référence absolue pour savoir à quel moment précis a été prise l'image, sans quoi le diagramme de rayonnement sera localement arbitrairement faussé d'un angle variable. Il doit être tenu compte dans la station d'ordinateur du flux des images et donc celui des positions calculées, et le flux des puissances RSSI mesurées relative au champ électromagnétique capté par le dispositif de réception 5.

Afin de garantir la synchronisation entre le flux des positions et flux des RSSI et pour permettre une éventuelle interpolation des positions mesurées pour une meilleure résolution de la mesure, le système de mesure 1 procède à un sur-échantillonnage de 40 fois entre deux images consécutives. Comme deux polarisations (Eₓ et E_{y}) sont mesurées, on obtient en fait une résolution de 1/20^{ème} de la variation d'angle entre deux positions consécutives. L'idée de base de la synchronisation consiste à échantillonner à la même fréquence (600 Hz) le signal d'ouverture disponible directement sur la caméra numérique. Ce signal est déclenché à la prise d'image et possède exactement la durée de l'exposition (env. 1 à 3 ms). Afin d'être échantillonné par la carte d'acquisition, ce signal très court est artificiellement allongé par une bascule monostable. Par post-traitement, il suffit de faire glisser le flux des positions calculées par rapport à celui des RSSI de telle manière que le flanc montant de la transition échantillonnée, qui représente la prise d'image, tombe sur la position calculée suivante. Le retard dû au calcul est toujours positif.

Une forme d'exécution du dispositif de réception 5 du système de mesure est présentée en référence à la figure 7. Il est à noter que pour effectuer la mesure de puissance des signaux RF, il est de préférence utilisé un récepteur 56 du commerce, qui est défini sous la référence SA626 de Philips. Ce récepteur 56 contient un récepteur de type hétérodyne à double changement de fréquence ainsi qu'un indicateur du niveau de puissance du signal reçu (RSSI pour Receive Signal Strength Indicator) rapide. La fréquence maximum de travail de ce composant ne dépasse pas 500 MHz. Un premier changement de fréquence assuré par un mélangeur externe 54 est donc nécessaire.

L'architecture RF du dispositif de réception 5 comprend traditionnellement un commutateur d'antennes 51 commandé par une logique de contrôle 52 pour relier soit une première antenne de réception 5', soit une seconde antenne de réception 5" polarisée différemment comme décrit ci-devant. Cette architecture RF comprend encore un amplificateur à filtre LNA 53, un mélangeur 54 pour opérer une conversion de fréquence, un filtre image 55 (69.7 MHz) qui fournit un signal filtré au récepteur SA626. Un bloc de synthétiseurs 58, qui est cadencé par des signaux fournis par un bloc d'oscillateurs 57, fournit un signal haute fréquence au mélangeur 54 pour opérer la première conversion de fréquence.

Des filtres IF céramiques cascadés non représentés peuvent encore être utilisés par exemple en sortie du récepteur 56 pour une mise en forme des signaux RSSI. Un convertisseur A/D 59 à 12 bits convertit les signaux analogiques en signaux numériques pour la logique de contrôle 52. Le filtre 69.3 MHz 55 est configuré pour jouer le double rôle de filtre et d'adaptation d'impédance. Les deux filtres céramiques IF 10.7 MHz sont standards et possèdent une largeur de bande d'environ 250 kHz.

Avec les deux antennes de réception 5' et 5", le système de mesure avec le dispositif de réception 5 permet une mesure sur deux polarisations orthogonales. Ce mode de mesure nécessite deux antennes orthogonales 5' et 5" en polarisation connectées sur les deux entrées RF du commutateur d'antennes 51. Une tension DC est optionnellement injectée sur les connecteurs RF afin de permettre l'alimentation d'un amplificateur LNA supplémentaire 53 directement en sortie des antennes. Ceci a pour but de supprimer la dégradation du seuil de bruit engendrée par les pertes dans les câbles de connexion des antennes. En mode de polarisation automatique, les antennes, qui mesurent le champ Eₓ respectivement le champ E_{y}, peuvent être alternativement commutées.

Deux amplificateurs LNA 53 à 50 Ohm large bande peuvent éventuellement être utilisés pour permettre une amplification d'environ 30 à 40 dB en amont du mélangeur 54. Ce mélangeur peut être du type doublement équilibré afin dé supprimer efficacement l'injection de la fréquence de mélange.

Afin de pouvoir couvrir les diverses fréquences intéressantes, par exemple GSM, ISM, Bluetooth, au moins trois synthétiseurs commutables 58 ont été conçus dans le bloc de synthétiseurs. Ces synthétiseurs couvrent les gammes 500-1000 MHz, 1370-2000 MHz et 2300-3000 MHz. La sélection est assurée par un commutateur de synthétiseurs 60 commandé par la logique de contrôle 52. Chaque synthétiseur est équipé d'une PLL programmable et possède un pas de fréquence de 100 kHz. Cette précision permet de présélectionner le signal souhaité afin qu'il tombe dans la largeur de bande d'un dernier filtre IF (env. 250 kHz). La programmation des différents synthétiseurs est réalisée par des signaux de commande fournis par la logique de contrôle 52.

Une deuxième conversion de fréquence peut être opérée à l'aide d'un second mélangeur du récepteur 56 SA626 avec des signaux de fréquence égale à 80 MHz fourni par le bloc d'oscillateurs 57. Ces signaux d'oscillateur sont générés par un quartz overtone à 80 MHz suivi d'un comparateur rapide. Un diviseur par 8 dans le bloc d'oscillateurs 57 permet de générer une référence à 10 MHz utile aux synthétiseurs 58 depuis cette horloge.

Le circuit récepteur 56 SA626 est équipé d'un RSSI rapide. Le temps d'établissement maximum de la tension RSSI est inférieur à 10 µs. Dans le mode de mesure avec interpolation entre deux positions calculées et changement de polarisation cette application nécessite en fait un temps d'établissement de l'ordre de 1 ms, 20 mesures par image fois 30 images par seconde représentent 600 mesures par seconde. Le SA626 est donc adapté au système de mesure selon l'invention.

Une carte d'acquisition 61 permet d'adapter les signaux de sortie du dispositif de réception vers la station d'ordinateur 7, ainsi que les signaux de programmation ou de commande fournis par la station d'ordinateur. La caméra numérique peut également être reliée à cette carte d'acquisition pour adapter les signaux de prise d'image à transférer à la station d'ordinateur. La logique programmable embarquée sur la carte permet ainsi de commander les différents blocs.

Il peut être prévu que la carte embarquée dans le dispositif de réception puisse posséder une alimentation de 5 V afin de générer localement une tension de 22 V à l'aide d'un convertisseur DC/DC non représenté. Cette tension est utilisée par les synthétiseurs (VCO) haute fréquence à grande dynamique de fréquence.

Une antenne de réception 51 peut être configurée également sous la forme d'une antenne GPS patch à polarisation circulaire, disposée sur un plan de masse rectangulaire de 7.5 x 8.5 cm. Toutefois pour le dispositif de réception du système de mesure, il peut être utilisé aussi une antenne cornet à double polarisation linéaire (2-18 GHz). L'antenne d'émission du dispositif électronique placé dans l'élément sphérique peut être susceptible de travailler à une fréquence de 2.443 GHz et fabriqué avec un dipôle ¼ onde.

Avec le système de mesure selon l'invention, la recherche du maximum du rayonnement d'une antenne quelconque avec un simple dipôle en polarisation nécessite normalement plusieurs heures pour une vitesse de rotation maximum de l'élément sphérique de l'ordre de 1 tour/s et un échantillonnage de 15 images/s. Ce temps peut être réduit à une dizaine de minutes dans le cas de la mesure de (Eₓ² + E_{y}²)^{1/2}.

A partir de la description qui vient d'être faite de multiples variantes de réalisation du système de mesure du diagramme de rayonnement d'une antenne d'émission peuvent être conçues par l'homme du métier sans sortir du cadre de l'invention définie par les revendications. Les moyens de détection peuvent être disposés sur le dispositif de positionnement, qui peut être commandé par l'intermédiaire de la station d'ordinateur.

## Revendications

1. Système de mesure (1) du diagramme de rayonnement d'une antenne d'émission (4'), le système comprenant un dispositif de réception (5) muni d'au moins une antenne de réception (5') fixe pour capter le champ électromagnétique produit par une antenne d'émission (4') à mesurer d'un dispositif électronique (4), un dispositif de positionnement (2) sur lequel est placé un élément de support (3) du dispositif électronique, le dispositif de positionnement comprenant des moyens pour entraîner notamment en rotation l'élément de support avec le dispositif électronique à antenne d'émission, des moyens de détection (6) de la position ou orientation de l'antenne d'émission, et une station de traitement des données (7) fournies par les moyens de détection et le dispositif de réception, **caractérisé en ce que** l'élément de support étant un élément sphérique creux à l'intérieur duquel est logé le dispositif électronique avec l'antenne d'émission à mesurer, et l'élément sphérique étant maintenu sur le dispositif de positionnement par gravité sur trois points d'appui (P, P', P"), dont un point d'appui est constitué par un organe d'entraînement (20, 21, 22) en contact avec la surface extérieure de l'élément sphérique pour le faire tourner aléatoirement dans toutes les directions sur le dispositif de positionnement,
les deux autres points d'appui du dispositif de positionnement sont constitués chacun par une rotule à bille (30, 40), dont la bille (31) est placée libre de rotation dans un logement (32) d'extrémité de la rotule pour qu'une portion de la bille débouche par une ouverture du logement pour venir en contact de la surface extérieure de l'élément sphérique (3), la portion de la rotule logeant la bille étant une buse pour amener de l'air comprimé afin que la bille soit maintenue dans son logement sur un coussin d'air.

2. Système de mesure selon la revendication 1, **caractérisé en ce que** l'organe d'entraînement (20) est une roue (21) venant en contact de la surface extérieure de l'élément sphérique pour l'entraîner en rotation, l'axe de rotation de la roue étant monté à l'extrémité d'un support (22) susceptible de tourner selon un autre axe passant par le point de contact de la roue sur la surface extérieure de l'élément sphérique et le centre dudit élément de manière à imposer une rotation aléatoire de l'élément sphérique par l'intermédiaire de la roue dans toutes les directions.

3. Système de mesure selon l'une des revendications précédentes, **caractérisé en ce que** les moyens de détection comprennent une caméra numérique (6) reliée à la station de traitement des données (7), et **en ce que** des figures ou références (10) sont réparties sur la surface extérieure de l'élément sphérique pour permettre à la caméra numérique associé à la station de traitement des données de déterminer la position ou orientation d'une antenne d'émission placée à proximité du centre de l'élément sphérique.

4. Système de mesure selon la revendication 3, **caractérisé en ce que** les figures ou références sont constituées par des codes à barres circulaires (10), chaque code à barres circulaires définissant une position précise de l'élément sphérique sur le dispositif de positionnement.

5. Système de mesure selon la revendication 4, **caractérisé en ce que** 14 codes à barres circulaires différents sont répartis uniformément sur la surface extérieure de l'élément sphérique, chaque code à barres circulaires étant codé sur 4 bits, ainsi qu'un bit de délimitation extérieure de couleur différente de la couleur de la surface extérieure de l'élément sphérique pour définir le bord de chaque figure.

6. Système de mesure selon la revendication 3, **caractérisé en ce qu'**il comprend un dispositif d'éclairage (9) pour éclairer uniformément la surface extérieure de l'élément sphérique visible par la caméra numérique.

7. Système de mesure selon la revendication 6, **caractérisé en ce que** le dispositif d'éclairage comprend un ensemble de fibres optiques (92) guidant de la lumière produite par une source de lumière distante de l'élément sphérique pour fournir un faisceau de lumière homogène afin d'améliorer la prise d'image de l'élément sphérique avec les différentes figures visibles par la caméra numérique.

8. Système de mesure selon la revendication 7, **caractérisé en ce que** l'ensemble de fibres optiques est réparti en plusieurs sous-ensembles (93) de fibres optiques, dont les extrémités des fibres optiques de chaque sous-ensemble à proximité de l'élément sphérique (3) sont fixées dans des plots plastiques (91) sur une structure d'éclairage (90).

9. Système de mesure selon la revendication 8, **caractérisé en ce que** la structure d'éclairage, qui est réalisée en un matériau non métallique, forme un anneau sur lequel plusieurs plots plastiques (91), par exemple 6 plots plastiques pour les extrémités des fibres optiques des sous-ensembles sont disposés sur toute la périphérie de l'anneau et à égale distance l'un de l'autre, l'anneau étant placé devant l'élément sphérique du côté de la caméra numérique (6) sans obstruer la vision de l'élément sphérique par la caméra numérique, et **en ce que** les extrémités des fibres optiques de chaque sous-ensemble sont orientées de manière à diriger des faisceaux de lumière en direction du centre de l'élément sphérique.

10. Système de mesure selon l'une des revendications 8 et 9, **caractérisé en ce que** le nombre de fibres optiques par sous-ensemble est d'au moins deux fibres optiques, de préférence 6 fibres optiques dont les extrémités fixées dans un des plots plastiques, qui sont à égale distance l'une de l'autre, sont agencées sous la forme de triangles équilatéraux.

## Patentansprüche

1. System (1) zum Messen des Strahlungsdiagramms einer Sendeantenne (4'), wobei das System eine Empfangsvorrichtung (5), die mit wenigstens einer festen Empfangsantenne (5') versehen ist, um das elektromagnetische Feld, das von einer zu messenden Sendeantenne (4') einer elektronischen Vorrichtung (4) erzeugt wird, aufzufangen, eine Positionierungsvorrichtung (2), an der ein Unterstützungselement (3) der elektronischen Vorrichtung angeordnet ist, wobei die Positionierungsvorrichtung Mittel zum insbesondere rotatorischen Antreiben des Unterstützungselements zusammen mit der elektronischen Vorrichtung mit Sendeantenne enthält, Detektionsmittel (6) für die Position oder die Orientierung der Sendeantenne und eine Station (7) für die Verarbeitung von Daten, die von den Detektionsmitteln und von der Empfangsvorrichtung geliefert werden, umfasst,
**dadurch gekennzeichnet, dass** das Unterstützungselement ein hohles sphärisches Element ist, in dem sich die elektronische Vorrichtung mit der zu messenden Sendeantenne befindet, und das sphärische Element an der Positionierungsvorrichtung durch die Schwerkraft an drei Abstützpunkten (P, P', P") gehalten wird, wobei ein Abstützpunkt durch ein Antriebsorgan (20, 21, 22), das mit der äußeren Oberfläche des sphärischen Elements in Kontakt ist, gebildet ist, um es zufällig in alle Richtungen an der Positionierungsvorrichtung zu drehen, und die zwei anderen Abstützpunkte der Positionierungsvorrichtung jeweils durch ein Kugelgelenk (30, 40) gebildet sind, wobei die Kugel (31) in einem Endaufnahmesitz (32) des Gelenks frei drehbar angeordnet ist, damit ein Teil der Kugel durch eine Öffnung des Aufnahmesitzes vorsteht, um mit der äußeren Oberfläche des sphärischen Elements (3) in Kontakt zu gelangen, wobei der Abschnitt des Gelenks, der die Kugel aufnimmt, eine Düse ist, um Druckluft zuzuführen, damit die Kugel in ihrem Aufnahmesitz auf einem Luftkissen gehalten wird.

2. Messsystem nach Anspruch 1, **dadurch gekennzeichnet, dass** das Antriebsorgan (20) ein Rad (21) ist, das mit der äußeren Oberfläche des sphärischen Elements in Kontakt ist, um es rotatorisch anzutreiben, wobei die Drehwelle des Rades an dem Ende eines Trägers (22) montiert ist, der sich um eine Achse drehen kann, die durch den Kontaktpunkt des Rades an der äußeren Oberfläche des sphärischen Elements und durch das Zentrum des Elements verläuft, derart, dass eine zufällige Drehung des sphärischen Elements mittels des Rades in allen Richtungen bewerkstelligt wird.

3. Messsystem nach einem der vorhergehenden Ansprüche, **dadurch gekennzeichnet, dass** die Detektionsmittel eine Digitalkamera (6) umfassen, die mit der Datenverarbeitungsstation (7) verbunden ist, und dass Figuren oder Bezugszeichen (10) auf der äußeren Oberfläche des sphärischen Elements verteilt sind, um der Digitalkamera, die der Datenverarbeitungsstation zugeordnet ist, zu ermöglichen, die Position oder die Orientierung einer Sendeantenne, die in der Nähe des Zentrums des sphärischen Elements angeordnet ist, zu bestimmen.

4. Messsystem nach Anspruch 3, **dadurch gekennzeichnet, dass** die Figuren oder Bezugszeichen durch kreisförmige Strichcodes (10) gebildet sind, wobei jeder kreisförmige Strichcode eine präzise Position des sphärischen Elements auf der Positionierungsvorrichtung definiert.

5. Messsystem nach Anspruch 4, **dadurch gekennzeichnet, dass** 14 verschiedene kreisförmige Strichcodes gleichmäßig auf der äußeren Oberfläche des sphärischen Elements verteilt sind, wobei jeder kreisförmige Strichcode mit 4 Bits sowie mit einem äußeren Begrenzungsbit mit einer anderen Farbe als die Farbe der äußeren Oberfläche des sphärischen Elements codiert ist, um den Rand jeder Figur zu definieren.

6. Messsystem nach Anspruch 3, **dadurch gekennzeichnet, dass** es eine Beleuchtungsvorrichtung (9) umfasst, um die äußere Oberfläche des sphärischen Elements, die für die Digitalkamera sichtbar ist, gleichmäßig zu beleuchten.

7. Messsystem nach Anspruch 6, **dadurch gekennzeichnet, dass** die Beleuchtungsvorrichtung eine Anordnung von Lichtleitfasern (92) umfasst, die Licht, das von einer Lichtquelle in einem Abstand von dem sphärischen Element erzeugt wird, leiten, um einen homogenen Lichtstrahl zu liefern, um die Bildaufnahme des sphärischen Elements mit den verschiedenen sichtbaren Figuren durch die Digitalkamera zu verbessern.

8. Messsystem nach Anspruch 7, **dadurch gekennzeichnet, dass** die Anordnung von Lichtleitfasern in mehreren Unteranordnungen (93) von Lichtleitfasern verteilt ist, wobei die Enden der Lichtleitfasern jeder Unteranordnung in der Nähe des sphärischen Elements (3) in plastischen Erhebungen (91) auf einer Beleuchtungsstruktur (90) befestigt sind.

9. Messsystem nach Anspruch 8, **dadurch gekennzeichnet, dass** die Beleuchtungsstruktur, die aus einem nicht metallischen Material verwirklicht ist, einen Ring bildet, auf dem mehrere plastische Erhebungen (91), beispielsweise 6 plastische Erhebungen, für die Enden der Lichtleitfasern von Unteranordnungen auf dem gesamten Umfang des Rings und in gleichem gegenseitigen Abstand angeordnet sind, wobei der Ring vor dem sphärischen Element auf Seiten der Digitalkamera (6) angeordnet ist, ohne die Sicht auf das sphärische Element für die Digitalkamera zu beeinträchtigen, und dass die Enden der Lichtleitfasern jeder Unteranordnung in der Weise orientiert sind, dass sie Lichtstrahlen in Richtung zum Zentrum des sphärischen Elements lenken.

10. Messsystem nach einem der Ansprüche 8 und 9, **dadurch gekennzeichnet, dass** die Anzahl von Lichtleitfasern pro Unteranordnung wenigstens zwei Lichtleitfasern, vorzugsweise 6 Lichtleitfasern, ist, deren Enden, die in den plastischen Erhebungen befestigt sind, die gleichmäßig voneinander beabstandet sind, in Form gleichseitiger Dreiecke angeordnet sind.

## Claims

1. System (1) for measuring the radiation diagram of a transmitting antenna (4'), the system including a receiver device (5) provided with at least one fixed receiving antenna (5') for picking up the electromagnetic field generated by a transmitting antenna (4') to be measured, belonging to an electronic device (4), a positioning device (2), on which a support element (3) for the electronic device is placed, the positioning device including means for driving the support element particularly in rotation with the electronic device comprising the transmitting antenna, means (6) for detecting the position or orientation of the transmitting antenna, and a data processing station (7) for data supplied by the detection means and the receiver device,
**characterized in that** the support element is a spherical hollow element, which houses the electronic device with the transmitting antenna to be measured, and the spherical element being held on the positioning device by gravity on three points of support (P, P', P"), one of which is formed by a drive member (20, 21, 22) in contact with the external surface of the spherical element to rotate said element randomly in every direction on the positioning device, and
**in that** the two other points of support of the positioning device are each formed by a ball and socket joint (30, 40), wherein the ball (31) is placed to rotate freely in an end housing (32) of the ball and socket joint, so that one portion of the ball emerges through an aperture in the housing to come into contact with the external surface of the spherical element (3), the portion of the ball and socket joint that houses the ball being a nozzle, for bringing compressed air, so that the ball is held in its housing on an air cushion.

2. Measuring system according to claim 1, **characterized in that** the drive member (20) is a wheel (21) that comes into contact with the external surface of the spherical element to drive said element in rotation, the rotating axle of the wheel being mounted at the end of a support (22) that can rotate along another axle, which passes through the point of contact of the wheel on the external surface of the spherical element and the centre of said element, so as to impose a random rotation on the spherical element via the wheel, in every direction.

3. Measuring system according to any one of the preceding claims, **characterized in that** the detection means include a digital camera (6), which is connected to the data processing station (7), and **in that** figures or references (10) are distributed over the external surface of the spherical element to enable the digital camera, associated with the data processing station, to determine the position or orientation of a transmitting antenna placed in proximity to the centre of the spherical element.

4. Measuring system according to claim 3, **characterized in that** the figures or references are formed by circular barcodes (10), each circular barcode defining a precise position of the spherical element on the positioning device.

5. Measuring system according to claim 4, **characterized in that** 14 different circular barcodes are uniformly distributed over the external surface of the spherical element, each circular barcode being encoded in 4 bits, and an external delimiting bit of a different colour to the colour of the external surface of the spherical element, to define the edge of each figure.

6. Measuring system according to claim 3, **characterized in that** it includes a lighting device (9) for lighting, in a uniform manner, the external surface of the spherical element that is visible to the digital camera.

7. Measuring system according to claim 6, **characterized in that** the lighting device includes a set of optical fibers (92) guiding light generated by a light source distant from the spherical element to provide a homogenous light beam to improve the image of the spherical element, with the various figures visible, captured by the digital camera.

8. Measuring system according to claim 7, **characterized in that** the set of optical fibers is divided into several sub-sets (93) of optical fibers, wherein the ends of the optical fibers of each sub-set in proximity to the spherical element (3) are secured in plastic studs (91) on a lighting structure (90).

9. Measuring system according to claim 8, **characterized in that** the lighting structure, which is made of a non-metal material, forms a ring, on which several plastic studs (91), for example 6 plastic studs, are arranged for the optical fiber ends of the sub-sets, over the entire periphery of the ring and equidistant from each other, the ring being placed in front of the spherical element on the side of the digital camera (6), without obstructing the digital camera's view of the spherical element, and **in that** the ends of the optical fibers of each sub-set are oriented so as to direct light beams in the direction of the centre of the spherical element.

10. Measuring system according to any one of claims 8 and 9, **characterized in that** the number of optical fibers per sub-set is at least two optical fibers, and preferably 6 optical fibers, whose ends, which are secured in one of the plastic studs, which are equidistant from each other, are arranged in the form of equilateral triangles.
